(19) Europäisches Patentamt
European Patent Office
Office européen des brevets

(11) **EP 2 534 701 B1**

(12) **EUROPÄISCHE PATENTSCHRIFT**

(45) Veröffentlichungstag und Bekanntmachung des Hinweises auf die Patenterteilung:
**21.11.2018 Patentblatt 2018/47**

(21) Anmeldenummer: **11701759.0**

(22) Anmeldetag: **24.01.2011**

(51) Int Cl.:
**H01L 31/054** *(2014.01)* **H01L 31/055** *(2014.01)*

(86) Internationale Anmeldenummer:
**PCT/EP2011/000280**

(87) Internationale Veröffentlichungsnummer:
**WO 2011/098212 (18.08.2011 Gazette 2011/33)**

(54) **PHOTOVOLTAIK-VORRICHTUNG SOWIE DESSEN VERWENDUNG**

PHOTOVOLTAIC DEVICE AND USE THEREOF

DISPOSITIF PHOTOVOLTAÏQUE ET SON UTILISATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.02.2010 DE 102010007763**

(43) Veröffentlichungstag der Anmeldung:
**19.12.2012 Patentblatt 2012/51**

(73) Patentinhaber: **Fraunhofer-Gesellschaft zur Förderung der angewandten Forschung e.V.**
**80686 München (DE)**

(72) Erfinder:
• **GOLDSCHMIDT, Jan, Christoph**
**63619 Bad Orb (DE)**
• **PETERS, Marius**
**72074 Tuebingen (DE)**

• **GOETZBERGER, Adolf**
**79249 Merzhausen (DE)**

(74) Vertreter: **Pfenning, Meinig & Partner mbB Patent- und Rechtsanwälte Theresienhöhe 11a 80339 München (DE)**

(56) Entgegenhaltungen:
**WO-A2-2009/128071 DE-A1-102007 058 971**
**FR-A1- 2 395 517 US-A1- 2007 227 581**
**US-A1- 2009 255 568**

• **A. GOETZBERGER; J.C. GOLDSCHMIDT; M. PETERS; P. LÖPER: "Light trapping, a new approach to spectrum splitting", SO LAR ENERGY MATERIALS & SOLAR CELLS, Bd. 92, 2008, Seiten 1570-1578, XP002669054, in der Anmeldung erwähnt**

**Beschreibung**

Die Erfindung betrifft eine Photovoltaik-Vorrichtung zur direkten Umwandlung von elektromagnetischer Strahlung in elektrische Energie sowie die Verwendung der Photovoltaik-Vorrichtung.

Der Großteil der heute am Markt verfügbaren Photovoltaikmodule nutzt ausschließlich eine Art von Solarzellen aus einem einzigen Halbleitermaterial. Der allergrößte Teil der Solarzellen wird dabei aus kristallinem Silizium produziert. Die Bandlücke des verwendeten Materials bestimmt im Wesentlichen, welche Photonen absorbiert werden können und wie hoch die Spannung der Solarzelle ist. Eine höhere Anzahl absorbierter Photonen und damit ein höherer Strom lassen sich durch eine niedrige Bandlücke erreichen, wodurch aber die Spannung sinkt. Mit nur einem Material mit ausschließlich einer Bandlücke lässt sich deshalb die im Sonnenspektrum enthaltene Energie nur unvollständig nutzen.

Eine bessere Ausnutzung des Sonnenspektrums lässt sich durch die Verwendung unterschiedlicher Solarzellenmaterialien mit unterschiedlichen Bandlücken erreichen. Diese werden nach dem Stand der Technik zu einem Stapel miteinander verbunden (A. De Vos, "On the formula for the upper limit of photovoltaic solar energy conversion efficiency", J. Phys. D: Appl. Phys., 15 (1982) 2003-2015). Nachteilig ist dabei, dass normalerweise die einzelnen Solarzellen in Serie miteinander über Tunneldioden miteinander verschaltet sind. Durch die Serienschaltung wird der Strom des Systems durch den niedrigsten Strom einer Solarzelle innerhalb des Stapels begrenzt, wodurch zum Teil hohe Verluste entstehen.

Eine andere Möglichkeit, die diesen Nachteil vermeidet, besteht darin, das Licht spektral aufzuteilen und die einzelnen Spektralbereiche auf unterschiedlichen Solarzellen zu verteilen (A. G. Imenes, D. Buie, D. R. Mills, P. Schramek, und S. G. Bosi, "A new strategy for improved spectral performance in solar power plants", Sol. Energy 80 (2006), 1263-1269; A. Barnett, "Milestones toward 50 % efficient solar cell modules", in: Proceedings of the 22nd European Photovoltaic Solar Energy Conference, Milan, Italy, 2007). Diese Systeme sind aber meist sehr komplex. Außerdem benötigen sie in den meisten Fällen eine aktive Nachführung und funktionieren nur unter direkter Sonneneinstrahlung.

Eine weitere Methode besteht in der Verwendung einer Lichtfalle basierend auf diffusem Licht (A. Goetzberger, J.C. Goldschmidt, M. Peters, P. Löper, "Light trapping, a new approach to spectrum splitting", Solar Energy Materials & Solar Cells, 92 (2008), 1570-1578).

DE 10 2007 058971 A1 betrifft eine Photovoltaik-Vorrichtung zur direkten Umwandlung von Sonnenenergie in elektrische Energie, die eine Lichtfalle zur Konzentrierung von Sonnenlicht aufweist, die mit den Solarzellen gekoppelt ist. In der Lichtfalle wird dabei durch Reflexion oder Streuung diffuse Strahlung erzeugt.

Ausgehend hiervon ist es Aufgabe der vorliegenden Erfindung, ein vereinfachtes Photovoltaik-Modul bereitzustellen, das eine höhere Anzahl von Photonen absorbieren kann, dabei weniger komplex ist und die in der Sonnenstrahlung enthaltene Energie effizienter ausnutzt.

Diese Aufgabe wird durch die Photovoltaik-Vorrichtung mit den Merkmalen des Anspruchs 1 gelöst. Anspruch 14 betrifft die Verwendung der Photovoltaik-Vorrichtung. Weitere vorteilhafte Ausführungsformen sind in den abhängigen Ansprüchen enthalten.

Die Photovoltaik-Vorrichtung zur direkten Umwandlung von elektromagnetischer Strahlung in elektrische Energie enthält erfindungsgemäß a) mindestens eine Lichtfalle, die aus einem transparentem Material mit einem höheren Brechungsindex als Luft besteht, wobei die Lichtfalle eine plane, der einfallenden Strahlung zugewandte Oberfläche und eine der einfallenden Strahlung abgewandte und mit einer Prismenstruktur versehende Oberfläche aufweist und die Prismen der Prismenstruktur jeweils eine erste und eine zweite Prismenfläche aufweisen, b) mindestens zwei Solarzellen, die unmittelbar an oder optisch gekoppelt mit mindestens zwei Prismenflächen angeordnet sind, dadurch gekennzeichnet, dass an benachbarten Prismenflächen Solarzellen mit unterschiedlicher spektraler Empfindlichkeit angeordnet sind und für die Winkel $\alpha_1$ und $\alpha_2$, den die Prismenflächen jeweils mit der Normalen der Lichteintrittsfläche bilden, gilt:

$$\alpha_1, \alpha_2 \leq \arccos(1/n)$$

mit n = Brechungsindex des Materials,
so dass die in die Lichtfalle eingefallene Strahlung nach Reflexion an den Prismenflächen durch Totalreflexion an der planen Oberfläche in der Lichtfalle (1) gehalten wird, wobei
zwischen mindestens einer Prismenfläche und mindestens einer Solarzelle mindestens eine spektral selektive Struktur angeordnet ist, die Strahlung des von der Solarzelle verwertbaren Spektralbereichs zumindest teilweise transmittiert und Strahlung des von der Solarzelle nicht verwertbaren Spektralbereichs zumindest teilweise reflektiert, und/oder unmittelbar an der von der Prismenfläche abgewandten Seite der mindestens einen Solarzelle und/oder auf mindestens einer Prismenfläche zumindest bereichsweise mindestens ein Reflektor, angeordnet ist.

Somit wird erfindungsgemäß die in die Lichtfalle eingefallene Strahlung nach Reflexion an den Prismenflächen durch Totalreflexion an den planen Oberflächen in der Lichtfalle gehalten.

Bei der hier beschriebenen Photovoltaik-Vorrichtung (PV-Vorrichtungen) handelt es sich um ein sehr einfaches System zum spektralen Management, das die Aufteilung des Sonnenspektrums auf beispielsweise zwei unterschiedliche Solarzellen erlaubt. Eine aktive Nachführung ist nicht zwingend erforderlich. Weiterhin kann auch diffuses Sonnenlicht genutzt werden. Die erfindungsgemäße PV-Vorrichtung lässt sich darüber hinaus einfach herstellen und ist auch mit Dünnschichttechnologie kombinierbar. Ein wesentlicher Unterschied zu aus dem Stand der Technik bekannten PV-Vorrichtungen besteht darin, dass kein diffuses Licht innerhalb der Vorrichtung benötigt wird und dass die Lichtfalle im Prinzip einen Wirkungsgrad von 100 % hat. Da die Fläche der Solarzellen ein Kostenfaktor ist, sollte der Winkel an der Prismenspitze möglichst groß gewählt sein.

Dabei ist es bevorzugt, dass an benachbarten Prismenflächen Solarzellen mit unterschiedlicher spektraler Empfindlichkeit angeordnet sind. In Abhängigkeit der Bandlücke des Solarzellenmaterials können folglich verschiedene spektrale Anteile des Lichts genutzt werden. So können unterschiedliche Spektralbereiche des Sonnenlichts verwertet werden. Dabei kann sich die Effizienz der Ausnutzung unterschiedlicher Spektralbereiche unterscheiden.

Gemäß einer ersten Ausführungsform der vorliegenden Erfindung ist es bevorzugt, dass zwischen mindestens einer Prismenfläche und mindestens einer Solarzelle mindestens eine spektral selektive Struktur angeordnet ist, die Strahlung des von der Solarzelle verwertbaren Spektralbereichs zumindest teilweise transmittiert und Strahlung des von der Solarzelle nicht verwertbaren Spektralbereichs zumindest teilweise reflektiert.

Dabei kann sich die spektral selektive Struktur zwischen mindestens einer Solarzelle und der Lichtfalle befinden, wobei die Solarzelle mit spektral selektiver Struktur im Vergleich zu der anderen Solarzelle in der Vorrichtung insbesondere die Energie von Photonen aus einem niederenergetischen Bereich effizient ausnutzt. Niederenergetische Photonen werden von Halbleitermaterialien mit einer vergleichsweise geringen Bandlücke absorbiert. Durch diese kann Licht im langwelligen Spektralbereich bzw. infraroten Spektralbereich absorbiert werden.

Die erfindungsgemäße Photovoltaik-Vorrichtung weist gemäß einer zweiten Ausführungsform unmittelbar an der von der Prismenfläche abgewandten Seite der mindestens einen Solarzelle und/oder auf mindestens einer Prismenfläche zumindest bereichsweise mindestens einen Reflektor, insbesondere in Form einer Beschichtung der Solarzelle und/oder Prismenfläche auf.

Es gilt die Maßgabe, dass die Merkmale der 1. und/oder 2. Ausführungsform verwirklicht werden.

Die erfindungsgemäße Photovoltaik-Vorrichtung kann auf mindestens einer Seitenfläche der Lichtfalle zumindest bereichsweise mindestens einen Reflektor, insbesondere in Form einer Beschichtung der Seitenfläche der Lichtfalle aufweisen.

Der Reflektor, der sich gegebenenfalls auf der von der Lichtfalle abgewandten Seite der Solarzelle befinden kann, ist vorteilhafterweise bei der Solarzelle angeordnet, die insbesondere Photonen mit höherer Energieeffizienz ausnutzt, also Licht aus dem kurzwelligen Spektralbereich.

Die spektral selektive Struktur ist bevorzugt in Form einer Beschichtung der Solarzelle und/oder Prismenfläche angeordnet. Weiterhin kann auch ein Reflektor in Form einer Beschichtung realisiert werden. In einer Variante der Photovoltaik-Vorrichtung kann zwischen der spektral selektiven Struktur und der Lichtfalle ein Zwischenraum vorliegen.

Die spektral selektive Struktur kann auch direkt mit mindestens einer Solarzelle gekoppelt sein.

Ein Zwischenraum kann auch zwischen der Lichtfalle und dem Reflektor vorliegen.

Weiterhin ist es auch möglich, dass zwischen einer spektral selektiven Struktur und einer Solarzelle ein Zwischenraum vorliegt.

Die spektral selektive Struktur besteht bevorzugt aus SiN, SiC, TiO, TaO, MgF, cholesterischen Flüssigkristallen, Polystyrol, und/oder Polymethylmethacrylat (PMMA) oder enthält diese im Wesentlichen.

Die spektral selektiven Strukturen können dabei durch Beschichtung, beispielsweise der Solarzelle, insbesondere mittels einer Form der Ionen-assistierenden Abscheidung (ion-assisted deposition) der chemischen Gasphasenabscheidung, insbesondere PECVD (plasmaunterstützte chemische Gasphasenabscheidung), der Atomlagendeposition, des Sputterns oder des Aufdampfens erfolgen. Weiterhin sind auch Lithographieverfahren, insbesondere Interferenz-Lithographie, Elektronenstrahl-Lithographie und Photo-Lithographie geeignet. Auch können direktes Laserschreiben (direct laser writing), nano-robotische Verfahren, selbst-organisierte Abscheideprozesse, Ätzprozesse wie auch holographische Prozesse für die Herstellung spektral selektiver Strukturen herangezogen werden.

Die Lichtfalle der erfindungsgemäßen Photovoltaik-Vorrichtung besteht bevorzugt aus Glas, transparentem Kunststoff und/oder Glaskeramik. Unter Transparenz bzw. transparentem Kunststoff ist hierbei zu verstehen, dass das Material im relevanten Spektralbereich eine sehr geringe Absorption sowie eine sehr geringe Streuung aufweist.

Das transparente Material weist bevorzugt einen Brechungsindex von mindestens 1,4, insbesondere mindestens 1,5 auf.

Die erfindungsgemäße Vorrichtung weist bevorzugt mindestens zwei Solarzellen aus Halbleitermaterialien mit unterschiedlichen Bandabständen auf. Folglich sind diese zwei Solarzellen dafür geeignet, Photonen mit unterschiedlichem Energieeinhalt zu absorbieren und somit einen größeren Bereich aus dem Spektrum des Sonnenlichts nutzen.

Dabei können die Solarzellen aus einem organischen Halbleitermaterial bestehen. Weiterhin können auch Farbstoff-Solarzellen eingesetzt werden. Die Solarzelle, die im Vergleich zu einer anderen Solarzelle der Vorrichtung insbesondere die Energie von Photonen aus einem höherenergetischen Bereich effizient ausnutzt, kann aus einem der folgenden Halbleitermaterialien oder deren chemischen Verbindungen bestehen: AlN, GaN, InN, SiC, ZnS, ZnSe, CdS, ZnTe, HgS, CdSe, CdTe, AlP, AlAs, AlSb, GaP, GaAs, InP, amorphem Silizium und/oder Si-Nanokristallen.

Die Solarzelle, die im Vergleich zu der vorher genannten Solarzelle insbesondere die Energie von Photonen aus einem niederenergetischen Bereich effizient nutzt, ist bevorzugt aus den folgenden Halbleitermaterialien oder deren chemischen Verbindungen ausgewählt: Si, Ge, mikrokristallinem Si, InAs, InSb, GaSb, HgTe und/oder HgSe.

Bevorzugt ist mindestens eine Solarzelle mit mindestens einem Element ausgestattet, das in der Lage ist, niederenergetische Photonen in höherenergetische Photonen zu konvertieren, insbesondere einem Hochkonverter.

Weiterhin können in einer Ausgestaltungsvariante der erfindungsgemäßen Photovoltaik-Vorrichtung die jeweiligen Bandlücken der Solarzellen mit unterschiedlichen Bandlücken so eingestellt werden, dass alle Solarzellen den gleichen Strom liefern. Dies ist insbesondere für die Schaltung der Solarzellen untereinander bevorzugt.

Die geometrischen Abmessungen der jeweiligen Solarzellen mit unterschiedlichen Bandlücken können so eingestellt sein, dass alle Solarzellen den gleichen Strom liefern.

Eine Zusammenschaltung mehrerer Solarzellen kann entlang einer Prismenachse die gleiche Spannung liefern, wie mindestens eine weitere Zusammenschaltung. Hierfür kann beispielsweise gelten:

$$3 \times U_{Solarzellenart\ 1} = 2 \times U_{Solarzellenart\ 2}$$

wobei hier die Solarzellenart 1 eine kleinere Bandlücke im Vergleich zu Solarzelle 2 aufweist, beispielsweise kann die Spannung der Solarzellenart 1 $U_{Solarzellenart\ 1}$ = 0,4 V und die Spannung der Solarzellenart 2 $U_{solarzellenart\ 2}$ = 0,6 V betragen, um die Gleichung zu erfüllen. Dies ist jedoch nur beispielhaft zu sehen.

Bevorzugt ist mindestens eine Solarzelle der Photovoltaik-Vorrichtung eine Tandemsolarzelle oder eine Mehrfachsolarzelle. Darüber hinaus ist auch ein Einsatz von Dünnschicht-Solarzellen denkbar.

Die mindestens eine Solarzelle weist bevorzugt eine Rückseitenkontaktierung auf.

Zur effizienten Ausnutzung der einfallenden Solarstrahlung kann die Prismenachse senkrecht oder parallel zum Lauf der Sonne ausgerichtet sein. Es ist auch denkbar, dass die Photovoltaik-Vorrichtung der Sonne nachführbar ist. Dies ist jedoch nicht zwingend erforderlich.

In einer bevorzugten Variante kann die einfallende Strahlung auf die Photovoltaik-Vorrichtung insbesondere durch Linsen, Spiegel und/oder Fluoreszenzkollektoren konzentriert werden. Dadurch ist eine weitere Steigerung der Effizienz gegeben.

An den Prismenflächen, an denen keine Solarzellen angebracht sind, können zumindest teilweise oder bereichsweise Reflektoren angeordnet sein.

In einer alternativen Ausführungsform kann an mindestens einer Prismenfläche eine weitere Lichtfalle angeordnet sein.

Dadurch steigt die Anzahl der verschiedene Spektralbereiche nutzenden Solarzellen deutlich, so dass der gesamte Spektralbereich des Sonnenlichts noch effektiver genutzt werden kann. Folglich ist eine Aufteilung des einfallenden Sonnenlichts auf bis zu 20 Solarzellenarten, bevorzugt 4 Solarzellenarten, möglich.

Die Prismenfläche kann mit einer Struktur oder Beschichtung versehen sein, die eine Reduzierung der Reflexion für zumindest einen Spektralbereich, der von der dahinter liegenden Vorrichtung ausnutzbar ist, bewirkt.

Bevorzugt ist eine Photovoltaik-Vorrichtung, die dadurch gekennzeichnet ist, dass die Reflexionseigenschaften der Lichteintrittsfläche in einem von der mindestens einen Solarzelle nutzbaren Spektralbereich, insbesondere durch eine Beschichtung oder durch Nanostrukturierung, reduziert ist. Negative Auswirkungen auf die Lichtführung durch Totalreflexion sind dabei nicht gegeben.

Damit kann ein größerer Anteil des Lichtes in die Lichtfalle gelangen, in elektrische Energie umgewandelt werden und damit der Wirkungsgrad der PV-Vorrichtung gesteigert werden.

Weiterhin kann die Prismenstruktur der erfindungsgemäßen PV-Vorrichtung dadurch ermöglicht sein, dass Stäbe mit einem dreieckigen Querschnitt nebeneinander angeordnet sind, die so eine Prismenstruktur bilden.

In einer weiteren Variante der Photovoltaik-Vorrichtung kann ein Körper mit einer Prismenstruktur unterhalb der Lichtfalle angeordnet sein. Die Prismenstruktur des Körpers bildet dabei bevorzugt die Negativstruktur zu der Primenstruktur der Lichtfalle.

In dieser Ausführungsform können die Solarzellen, Reflektoren und/oder spektral selektiven Struktur an dem Körper direkt angeordnet, insbesondere formschlüssig verbunden, sein. Es können jedoch auch Zwischenräume zwischen dem Körper und den Solarzellen, Reflektoren und/oder spektral selektiven Struktur vorliegen.

Weiterhin können die Solarzellen, Reflektoren und/oder spektral selektiven Strukturen jeweils mit der angrenzenden Prismenfläche, entweder der Lichtfalle oder des Körpers, verbunden sein. Diese können direkt oder mit Zwischenräumen angeordnet sein.

Der Körper kann aus verschiedenen Materialien bestehen. Vorteilhafterweise besteht er aus Materialien, die einen ähnlichen Wärmeausdehnungskoeffizienten wie das Material der Lichtfalle aufweisen, so dass ein Vorliegen von thermischen Spannungen weitgehend unterbunden werden kann.

Das Material für den Körper muss nicht transparent sein. Weiterhin ist es bevorzugt, wenn der Köper sowie die Lichtfalle ineinander gesetzt und gegebenenfalls miteinander verbunden sind, so dass ein Modul mit zwei glatten Seiten erhalten wird. Unter den glatten Seiten sind hierbei insbesondere die dem Sonnenlicht zugewandte Seite der Lichtfalle und die vom Sonnenlicht abgewandte Seite des Körpers zu verstehen.

Erfindungsgemäß wird die Photovoltaik-Vorrichtung zur Umwandlung von Sonnenenergie in elektrische Energie oder zur Detektion von elektromagnetischer Strahlung verwendet.

Anhand der nachfolgenden Figuren 1 bis 8 sowie Beispiel 1 soll der erfindungsgemäße Gegenstand näher erläutert werden, ohne diesen auf diese Varianten einzuschränken.

Es zeigt

Figur 1     eine Konfiguration der Photovoltaik-Vorrichtung mit spektraler Trennung;

Figur 2     eine Konfiguration der Photovoltaik-Vorrichtung mit mehrfacher spektraler Trennung;

Figur 3     eine Photovoltaik-Vorrichtung in einer Konfiguration als Konzentrator;

Figur 4     einen möglichen Lichtweg des einfallenden Lichtes innerhalb der Lichtfalle;

Figur 5     eine Definition vom Prismenwinkel $\alpha$;

Figur 6     eine Ausführungsform mit einem Reflektor an den seitlichen Stirnflächen;

Figur 7     eine Schaltungsanordnung entlang der Prismenachse;

Figur 8     die erfindungsgemäße Photovoltaik-Vorrichtung einschließlich des Lichtweges; Und

Figur 9     die erfindungemäße Photovoltaik-Vorrichtung mit einem darunter liegenden Körper.

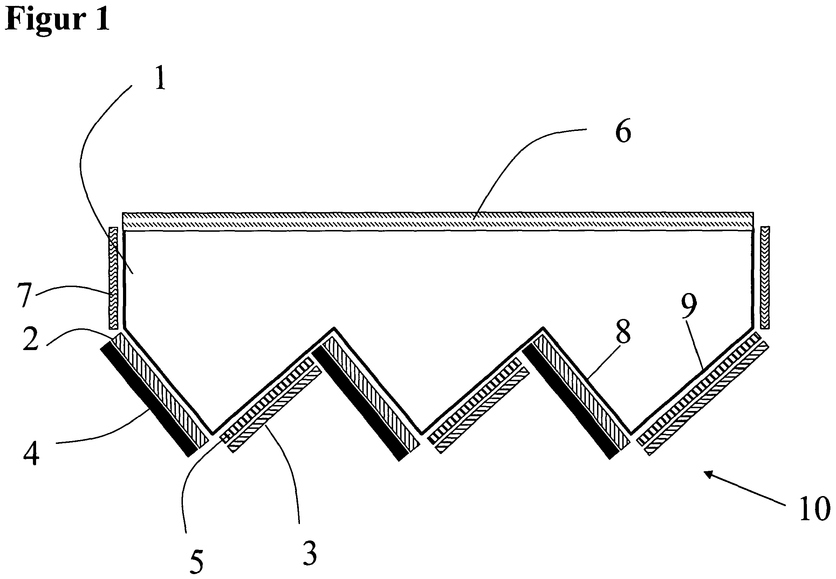

In Figur 1 ist eine Photovoltaik-Vorrichtung 10 dargestellt, wobei diese Konfiguration eine spektrale Trennung aufweist. Der Lichtfallenkörper 1 weist auf der dem Sonnenlicht zugewandten Seite eine Beschichtung 6 auf. Diese verringert die Reflexion von spektral nutzbarem Licht an der Oberfläche der Lichtfalle 1. An den Seiten der Lichtfalle 1 ist in dieser Ausführungsform jeweils ein Reflektor 7 angeordnet. Die Solarzelle 2 grenzt unmittelbar an die erste Prismenfläche 8 an oder ist mit dieser optisch gekoppelt. Auf der von der Lichtfalle abgewandten Seite der Solarzelle 2 ist ein Reflektor 4 angeordnet. Dieser reflektiert zumindest die transmittierten Photonen. Die Solarzelle 2 absorbiert in erster Linie Photonen mit höherer Energie als die Solarzelle 3. Die Solarzelle 3 ist an der zweiten Prismenfläche 9 angeordnet, wobei in dieser Ausführungsform zwischen der zweiten Prismenfläche 9 und der Solarzelle 3 eine spektral selektive Struktur 5 angeordnet ist. Die spektral selektive Struktur 5 transmittiert dabei zumindest teilweise die Strahlung, die von der Solarzelle 3 verwertet werden kann.

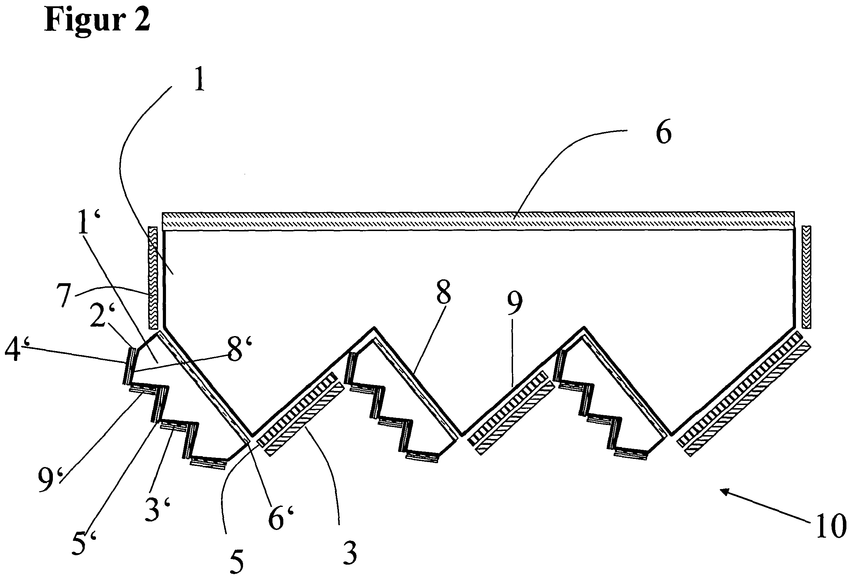

In Figur 2 ist eine Photovoltaik-Vorrichtung 10 dargestellt, wobei diese Konfiguration eine mehrfache spektrale Trennung aufweist. Die Lichtfalle 1 weist auf der dem Sonnenlicht zugewandten Oberfläche eine Beschichtung 6 auf. An den Seitenflächen der Lichtfalle 1 ist jeweils ein Reflektor 7 zumindest bereichsweise angeordnet. In dieser Ausführungsform ist an der ersten Prismenfläche 8 eine weitere beschichtete Lichtfalle 1' angeordnet. An der zweiten Prismenfläche 9 sind eine spektral selektive Struktur 5 sowie eine Solarzelle 3 angeordnet. Die an der ersten Prismenfläche 8 angeordnete Lichtfalle 1' weist hierbei eine vergleichbare Struktur wie die Photovoltaik-Vorrichtung gemäß Figur 1 auf. Die Oberfläche der Lichtfalle 1' ist hierbei mit einer Antireflexschicht 6' beschichtet. Auf der ersten Prismenfläche 8' ist eine Solarzelle 2' angeordnet. Auf der Rückseite der Solarzelle 2' ist ein Reflektor 4' angeordnet. Auf der zweiten Prismenfläche 9' ist eine weitere spektral selektive Struktur 5' angeordnet, auf deren Rückseite die Solarzelle 3' angeordnet ist. Die an der Lichtfalle 1' angeordneten Solarzellen 2' absorbieren Photonen mit höherer Energie im Vergleich zu den Solarzellen 3'. Hierbei ist es jedoch nicht erforderlich, dass alle Solarzellen 2' eine identische Bandlücke aufweisen. Das gleiche gilt für die Solarzellen mit dem Bezugszeichen 3'.

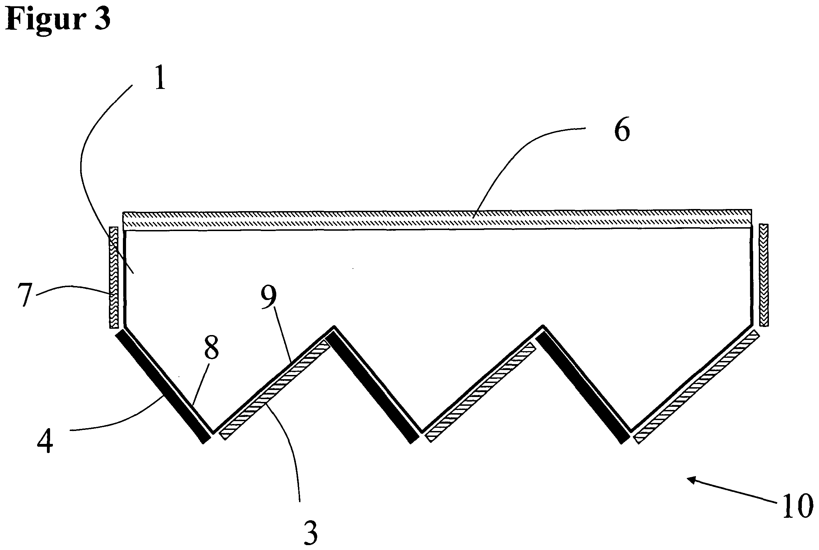

In Figur 3 ist eine erfindungsgemäße Photovoltaik-Vorrichtung 10 dargestellt, wobei diese eine Konfiguration als Konzentrator besitzt. An der Seite der Lichtfalle 1 ist jeweils ein Reflektor 7 zumindest bereichsweise angeordnet. Unmittelbar an der ersten Prismenfläche 8 bzw. mit der ersten Prismenfläche 8 optisch gekoppelt sind die Reflektoren 4. An der zweiten Prismenfläche 9 sind Solarzellen 3 angeordnet. Die Lichtfalle 1 weist auf der dem Sonnenlicht zugewandten Seite eine Nanostrukturierung 6 oder Beschichtung auf.

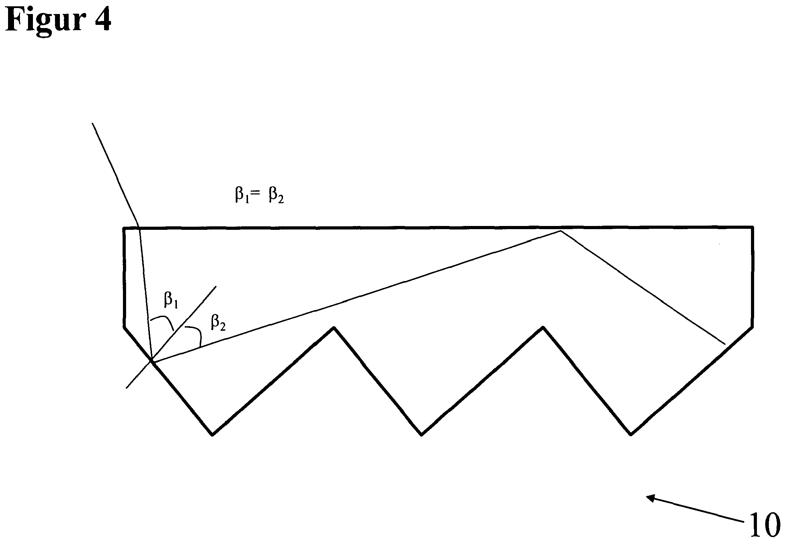

In Figur 4 ist der mögliche Lichtweg der einfallenden Solarstrahlung auf die Photovoltaik-Vorrichtung 10 dargestellt. Hierbei ist der Winkel $\beta_1$ gleich dem Winkel $\beta_2$.

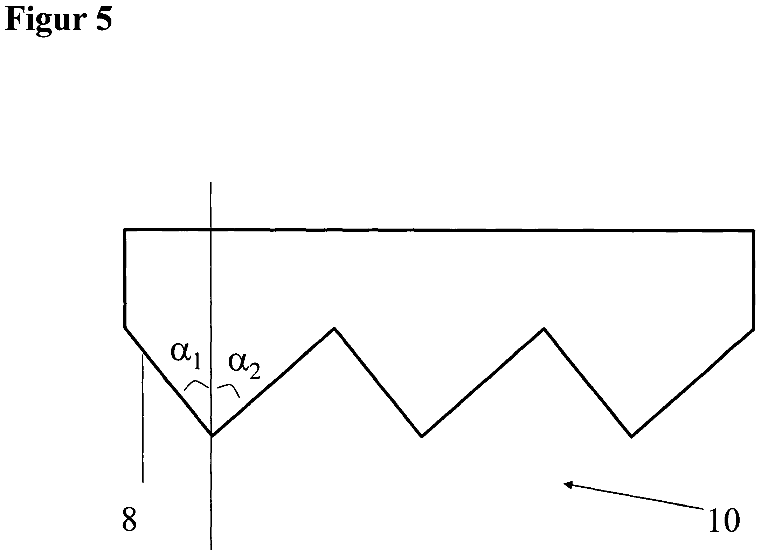

In Figur 5 sind die Prismenwinkel $\alpha_1$ und $\alpha_2$ definiert. Dies sind die Winkel, die zwischen einem Lot, das auf die Oberfläche der Photovoltaik-Vorrichtung 10 gefällt wurde, und der ersten Prismenfläche 8 bzw. der zweiten Prismenfläche 9 eingeschlossen werden.

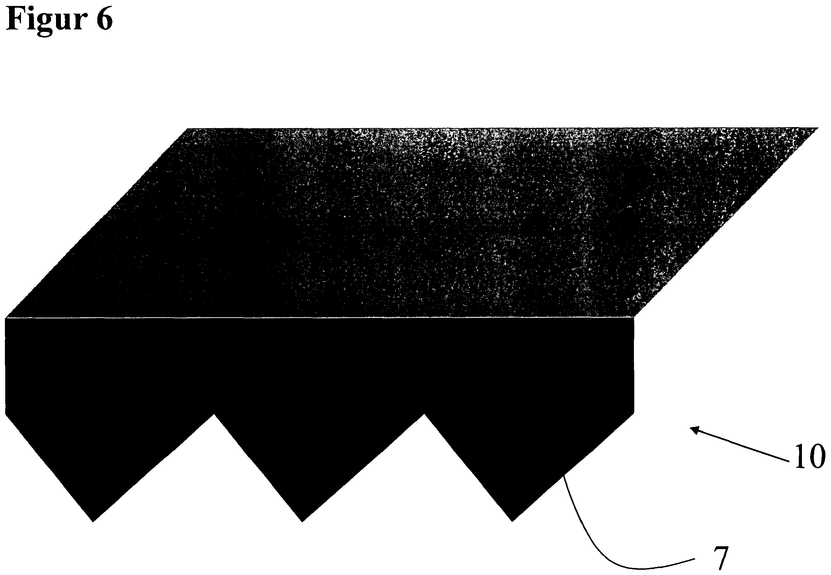

Figur 6 zeigt eine räumliche Darstellung der erfindungsgemäßen Photovoltaik-Vorrichtung 10. Hierbei ist ein reflektierendes Element 7 an den seitlichen Stirnflächen angebracht.

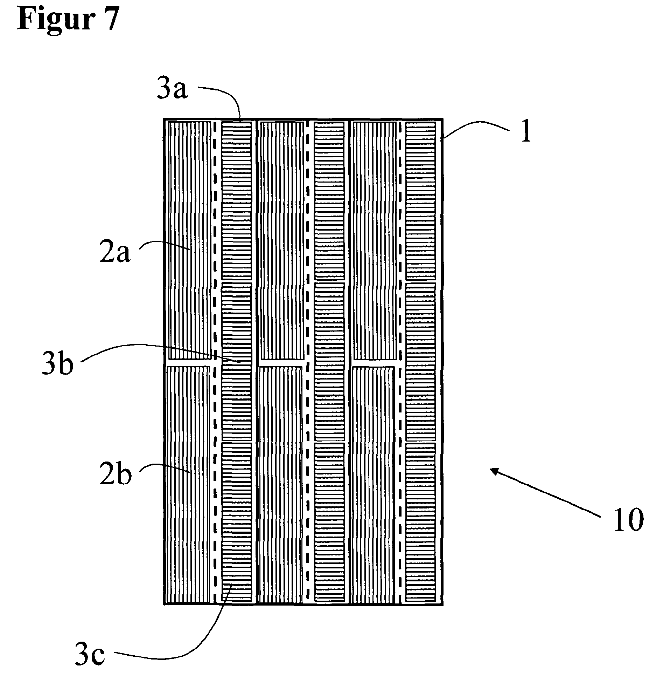

Figur 7 zeigt eine Anordnung, die eine verlustarme Parallelschaltung von Reihenschaltungen entlang der Prismenachse erlaubt. Hier ist die Photovoltaik-Vorrichtung 10 in einer Ansicht von unten dargestellt. Die Solarzellen 2a und 2b sind in Reihe geschaltet. Weiterhin sind die Solarzellen 3a, 3b und 3c in Reihe geschaltet. Die Solarzellen 2a + 2b sind zu den Solarzellen 3a + 3b + 3c parallel geschaltet. Die Solarzellen 2a sowie 2b absorbieren hierbei Photonen, die eine höhere Energie im Vergleich zu den Photonen aufweisen, die von den Solarzellen 3a, 3b sowie 3c absorbiert werden. Folglich weisen die Solarzellen 2a und 2b eine höhere Bandlücke auf als die Solarzellen 3a, 3b und 3c. Im Falle eines derartigen Aufbaus der erfindungsgemäßen Photovoltaik-Vorrichtung 10 ist:

$$3 \text{ x } U_{\text{Solarzellenart 3}} = 2 \text{ x } U_{\text{Solarzellenart 2}}$$

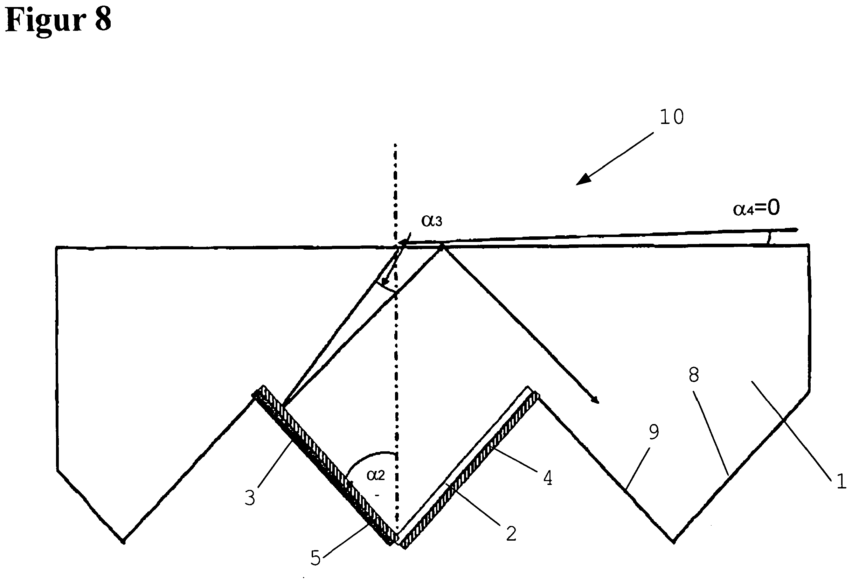

In Figur 8 ist eine weitere Ausführungsform der erfindungsgemäßen Photovoltaik-Vorrichtung 10 dargestellt. Hierbei ist eine Solarzelle 2 mit reflektierender Rückseite 4 an der ersten Prismenfläche 8 angeordnet. An der zweiten Prismenfläche 9 ist als spektral selektive Struktur 5 ein selektiver Spiegel angeordnet. Auf der von der Lichtfalle 1 abgewandten Seite des selektiven Spiegels ist eine Solarzelle 3 angeordnet.

Figur 8 stellt einen Schnitt durch eine Prismenstruktur dar. Das gesamte in die Lichtfalle 1 eindringende Licht wird innerhalb des Mediums in einen Lichtkegel entsprechend dem Grenzwinkel der Totalreflexion gebündelt. Hier ist $\alpha_3$ der Grenzwinkel bei flachem Einfall ($\sin \alpha_4 = 1$, $n = 1,5$), daher $\alpha_3 = 41,8°$. Bei einem Sägezahnwinkel von 45° wird der Strahl so reflektiert, dass er die Oberfläche innerhalb der Totalreflexion trifft. Das trifft dann auch für alle anderen Strahlen innerhalb des Eintrittswinkels zu und gegebenenfalls auch für schräge Strahlen, die nicht innerhalb der Zeichenebene liegen. Nach der Totalreflexion wird der Strahl an der nächsten Sägezahnfläche absorbiert. Das meiste Licht wird sogar direkt auf die gegenüberliegende Fläche reflektiert und dort absorbiert. Dasselbe gilt auch für die gegenüberliegende Sägezahnfläche. Somit ist diese Sägezahngeometrie bei einmaliger Reflexion und anschließender Absorption eine ideale Lichtfalle.

Der erfindungsgemäße Aufbau weist eine prismatische Struktur aus transparentem, lichtbrechendem Material mit Sägezahnstruktur im Querschnitt auf, an die zwei unterschiedliche Solarzellen an gegenüberliegenden Seiten der Sägezähne angebracht sind (Figur 8). Die Solarzellen können jeweils nur einen bestimmten Spektralbereich ausnutzen, für den sie am effizientesten sind. Dies lässt sich wie folgt realisieren: Die Solarzelle mit einer hohen Bandlücke transmittiert Photonen mit niedrigen Energien. Diese werden von einer reflektierenden Rückseite zurück in das transparente Material geworfen. Vor oder auf die Solarzelle mit einer niedrigen Bandlücke wird ein selektiver Reflektor angebracht, der Photonen mit hohen Energien zurückwirft.

Erfindungswesentlich ist, dass das Licht bei Eintritt in das System gebrochen wird. Dadurch wird selbst Licht, das unter einem sehr flachem Winkel auf das System trifft (wie Teile des diffusen Lichtes oder streifender Lichteinfall bei Systemen ohne Nachführung), so auf eine der Solarzellen treffen, dass, sollte es nicht in dieser Solarzelle absorbiert werden, es nach der Reflexion mit einer sehr hohen Wahrscheinlichkeit auf eine Solarzelle des anderen Materials trifft.

Da die Einschränkung des internen Winkelbereiches durch Brechung und Totalreflexion ausgenutzt werden, benötigt dieses System zur spektralen Trennung keine Nachführung. Dies ist ein entscheidender Vorteil.

Da die Fläche der Solarzellen ein Kostenfaktor ist, sollte der Winkel an der Prismenspitze möglichst groß gewählt sein. Es wird hier eine mathematische Beziehung für den maximalen Prismenwinkel angegeben. In Figur 8 ist $\alpha_3$ der Grenzwinkel bei flachem Einfall ($\alpha_4 = 0$). Bei einem maximalen Sägezahnwinkel wird der Strahl in sich selbst reflektiert und er trifft die Oberfläche an der Grenze der Totalreflexion. Alle anderen Strahlen, und auch schräge Strahlen, die nicht innerhalb der Zeichenebene liegen, werden dann totalreflektiert. Daraus folgt:

$$\alpha_2 = \text{arc } \cos(1/n)$$

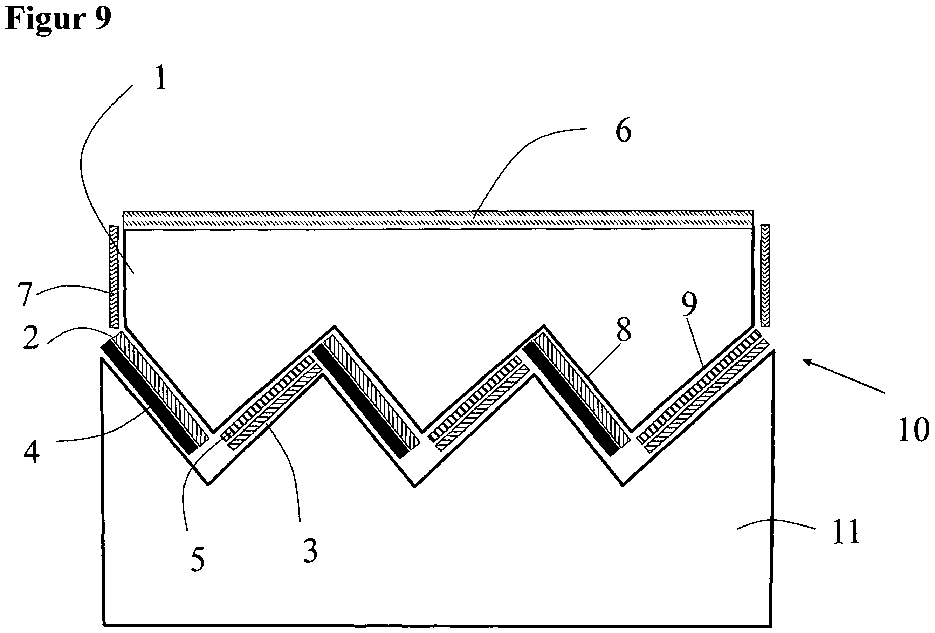

Figur 9 zeigt eine erfindungsgemäße Photovoltaik-Vorrichtung 10 mit spektraler Trennung, wobei auf deren Unterseite ein Körper 11 angeordnet ist. Der Lichtfallenkörper 1 weist auf der dem Sonnenlicht zugewandten Seite eine Beschichtung 6 auf. Diese verringert die Reflexion von spektral nutzbarem Licht an der Oberfläche der Lichtfalle 1. An den Seiten der Lichtfalle 1 ist in dieser Ausführungsform jeweils ein Reflektor 7 angeordnet. Die Solarzelle 2 grenzt unmittelbar an die erste Prismenfläche 8 an oder ist mit dieser optisch gekoppelt. Auf der von der Lichtfalle abgewandten Seite der Solarzelle 2 ist ein Reflektor 4 angeordnet. Dieser reflektiert zumindest die transmittierten Photonen. Die Solarzelle 2 absorbiert in erster Linie Photonen mit höherer Energie als die Solarzelle 3. Die Solarzelle 3 ist an der zweiten Prismenfläche 9 angeordnet, wobei in dieser Ausführungsform zwischen der zweiten Prismenfläche 9 und der Solarzelle 3 eine spektral selektive Struktur 5 angeordnet ist. Die spektral selektive Struktur 5 transmittiert dabei zumindest teilweise die Strahlung, die von der Solarzelle 3 verwertet werden kann.

**Beispiel 1**

Die Systemarchitektur der erfindungsgemäßen PV-Vorrichtung ist sehr einfach und lässt sich z.B. mit Dünnschichttechnologien kombinieren. Dafür wird zunächst die eine Art der Solarzellen auf die Sägezahnflächen der einen Orientierung abgeschieden, während die anderen Flächen z.B. durch Masken abgedeckt oder durch Schrägstellung der Substrate abgeschattet sind, und anschließend die anderen Flächen.

Die streifenförmigen Solarzellen einer Art könnten innerhalb eines Streifens so unterteilt und verbunden werden, dass schlussendlich jeder Streifen die gleiche Spannung liefert und ein komplettes Modul durch einfache Parallelschaltung aller Streifen realisiert wird.

**Patentansprüche**

1.  Photovoltaik-Vorrichtung (10) zur direkten Umwandlung von elektromagnetischer Strahlung in elektrische Energie enthaltend

    a) mindestens eine Lichtfalle (1), die aus einem transparentem Material mit einem höheren Brechungsindex als Luft besteht, wobei die Lichtfalle (1) eine plane, der einfallenden Strahlung zugewandte Oberfläche und eine der einfallenden Strahlung abgewandte und mit einer Prismenstruktur versehende Oberfläche aufweist und die Prismen der Prismenstruktur jeweils eine erste (8) und eine zweite (9) Prismenfläche aufweisen,
    b) mindestens zwei Solarzellen (2, 3), die unmittelbar an oder optisch gekoppelt mit mindestens zwei Prismenflächen (8, 9) angeordnet ist,

    **dadurch gekennzeichnet, dass** an benachbarten Prismenflächen (8, 9) Solarzellen (2, 3) mit unterschiedlicher spektraler Empfindlichkeit angeordnet sind und für die Winkel $\alpha_1$ und $\alpha_2$, den die Prismenflächen (8, 9) jeweils mit der Normalen der Lichteintrittsfläche bilden, gilt:

$$\alpha_1, \alpha_2 \leq \arccos(1/n)$$

    mit n = Brechungsindex des Materials,
    so dass die in die Lichtfalle (1) eingefallene Strahlung nach Reflexion an den Prismenflächen (8, 9) durch Totalreflexion an der planen Oberfläche in der Lichtfalle (1) gehalten wird, wobei
    zwischen mindestens einer Prismenfläche (8, 9) und mindestens einer Solarzelle (2, 3) mindestens eine spektral selektive Struktur (5) angeordnet ist, die Strahlung des von der Solarzelle (2, 3) verwertbaren Spektralbereichs zumindest teilweise transmittiert und Strahlung des von der Solarzelle (2, 3) nicht verwertbaren Spektralbereichs zumindest teilweise reflektiert, und/oder unmittelbar an der von der Prismenfläche (8, 9) abgewandten Seite der mindestens einen Solarzelle (2, 3) und/oder auf mindestens einer Prismenfläche (8, 9) zumindest bereichsweise mindestens ein Reflektor (4, 7), angeordnet ist.

2.  Photovoltaik-Vorrichtung (10) nach Anspruch 1, **dadurch gekennzeichnet, dass** der Reflektor in Form einer Beschichtung der Solarzelle (2, 3) und/oder Prismenfläche (8, 9) vorliegt.

3.  Photovoltaik-Vorrichtung (10) nach einem der Ansprüche 1 bis 2, **dadurch gekennzeichnet, dass** auf mindestens einer Seitenfläche der Lichtfalle (1) zumindest bereichsweise mindestens ein Reflektor (4, 7), insbesondere in Form einer Beschichtung der Seitenfläche der Lichtfalle (1), angeordnet ist.

4.  Photovoltaik-Vorrichtung (10) nach einem der Ansprüche 2 oder 3, **dadurch gekennzeichnet, dass** die spektral selektive Struktur (5) in Form einer Beschichtung der Solarzelle (2, 3) und/oder Prismenfläche (8, 9) angeordnet ist.

5. Photovoltaik-Vorrichtung (10) nach einem der Ansprüche 2 bis 4, **dadurch gekennzeichnet, dass** die mindestens eine spektral selektive Struktur (5) aus SiN, SiC, TiO, PMMA, TaO, Polystyrol, cholesterischen Flüssigkristallen und/oder MgF besteht oder diese im Wesentlichen enthält.

6. Photovoltaik-Vorrichtung (10) nach einem der Ansprüche 1 bis 5, **dadurch gekennzeichnet, dass** die Lichtfalle (1) aus Glas, transparentem Kunststoff und/oder Glaskeramik besteht.

7. Photovoltaik-Vorrichtung (10) nach einem der Ansprüche 1 bis 6, **dadurch gekennzeichnet, dass** das transparente Material

   a) einen Brechungsindex von mindestens 1,4, insbesondere mindestens 1,5 aufweist, und/oder
   b) das gesamte in die Lichtfalle (1) eindringende Licht in einen Lichtkegel entsprechend dem Grenzwinkel der Totalreflexion bündelt.

8. Photovoltaik-Vorrichtung (10) nach einem der Ansprüche 1 bis 7, **dadurch gekennzeichnet, dass** die Vorrichtung mindestens zwei Solarzellen (2, 3) aus Halbleitermaterialien mit unterschiedlichen Bandabständen aufweist und/oder mindestens eine Solarzelle (2, 3) eine Tandemsolarzelle oder Mehrfachsolarzelle ist.

9. Photovoltaik-Vorrichtung (10) nach einem der Ansprüche 1 bis 8, **dadurch gekennzeichnet, dass** mindestens eine Solarzelle (2, 3) mit mindestens einem Element ausgestattet ist, das in der Lage ist, niederenergetische Photonen in höherenergetische Photonen zu konvertieren, insbesondere einem Hochkonverter.

10. Photovoltaik-Vorrichtung (10) nach einem der Ansprüche 1 bis 9, **dadurch gekennzeichnet, dass** die jeweiligen Bandlücken der Solarzellen (2, 3) mit unterschiedlichen Bandlücken so eingestellt werden, dass alle Solarzellen (2, 3) den gleichen Strom liefern und/oder die geometrische Abmessung der jeweiligen Solarzellen (2, 3) mit unterschiedlichen Bandlücken so eingestellt ist, dass alle Solarzellen (2, 3) den gleichen Strom liefern.

11. Photovoltaik-Vorrichtung (10) gemäß einem der Ansprüche 1 bis 10, **dadurch gekennzeichnet, dass** eine Zusammenschaltung mehrere Solarzellen (2, 3) entlang einer Prismenachse die gleiche Spannung liefert, wie mindestens eine weitere Zusammenschaltung.

12. Photovoltaik-Vorrichtung (10) gemäß einem der Ansprüche 1 bis 11, **dadurch gekennzeichnet, dass** einfallende Strahlung auf die Photovoltaik-Vorrichtung konzentrierbar ist, insbesondere durch Linsen, Spiegel und/oder Fluoreszenzkollektoren.

13. Photovoltaik-Vorrichtung (10) gemäß einem der Ansprüche 1 bis 12, **dadurch gekennzeichnet, dass** die Reflexionseigenschaften der Lichteintrittsfläche in einem von der mindestens einen Solarzelle (2, 3) nutzbaren Spektralbereich, insbesondere durch eine Beschichtung (6) oder durch Nanostrukturierung (6), reduziert ist.

14. Photovoltaik-Vorrichtung (10) gemäß einem der Ansprüche 1 bis 13, **dadurch gekennzeichnet, dass** ein Körper mit einer Prismenstruktur (1') unterhalb der Lichtfalle (1) angeordnet ist.

15. Verwendung der Photovoltaik-Vorrichtung (10) nach einem der Ansprüche 1 bis 14 zur Umwandlung von Sonnenenergie in elektrische Energie oder zur Detektion von elektromagnetischer Strahlung.

**Claims**

1. Photovoltaic device (10) for direct conversion of electromagnetic radiation into electrical energy, comprising

   a) at least one light trap (1) which consists of a transparent material with a higher refractive index than air, the light trap (1) having a planar surface which is orientated towards the incident radiation and a surface which is orientated away from the incident radiation and provided with a prism structure, and the prisms of the prism structure having respectively a first (8) and a second (9) prism surface,
   b) at least two solar cells (2, 3) which are disposed directly on or optically coupled to at least two prism surfaces (8, 9),

**characterised in that**, on adjacent prism surfaces (8, 9), solar cells (2, 3) with different spectral sensitivity are disposed and, for the angles $\alpha_1$ and $\alpha_2$, which the prism surfaces (8, 9) respectively form with the normal to the light incidence surface, there applies:

$$\alpha_1, \alpha_2 \leq \arccos(1/n)$$

with n = refractive index of the material,
so that the radiation incident in the light trap (1) after reflection on the prism surfaces (8, 9) is retained in the light trap (1) by total reflection on the planar surface,
between at least one prism surface (8, 9) and at least one solar cell (2, 3), at least one spectrally selective structure (5) being disposed, which transmits radiation of the spectral range useable by the solar cell (2, 3) at least partially and reflects radiation of the spectral range which is not useable by the solar cell (2, 3) at least partially, and/or directly on the side which is orientated away from the prism surface (8, 9) of the at least one solar cell (2, 3) and/or on at least one prism surface (8, 9), at least one reflector (4, 7) being disposed at least in regions.

2. Photovoltaic device (10) according to claim 1, characterised that the reflector is present in the form of a coating of the solar cell (2, 3) and/or prism surface (8, 9).

3. Photovoltaic device (10) according to one of the claims 1 to 2, **characterised in that**, on at least one side surface of the light trap (1), at least one reflector (4, 7), in particular in the form of a coating of the side surface of the light trap (1), is disposed at least in regions.

4. Photovoltaic device (10) according to one of the claims 2 or 3, **characterised in that** the spectrally selective structure (5) is disposed in the form of a coating of the solar cell (2, 3) and/or prism surface (8, 9).

5. Photovoltaic device (10) according to one of the claims 2 to 4, **characterised in that** the at least one spectrally selective structure (5) consists of SiN, SiC, TiO, PMMA, TaO, polystyrene, cholesteric liquid crystals and/or MgF or essentially comprises these.

6. Photovoltaic device (10) according to one of the claims 1 to 5, **characterised in that** the light trap (1) consists of glass, transparent plastic material and/or glass ceramics.

7. Photovoltaic device (10) according to one of the claims 1 to 6, **characterised in that** the transparent material

   a) has a refractive index of at least 1.4, in particular at least 1.5,
   and/or
   b) bundles the totality of the light penetrating into the light trap (1) into a light cone corresponding to the boundary angle of the total reflection.

8. Photovoltaic device (10) according to one of the claims 1 to 7, **characterised in that** the device has at least two solar cells (2, 3) made of semiconductor materials with different band gaps and/or at least one solar cell (2, 3) is a tandem solar cell or multiple solar cell.

9. Photovoltaic device (10) according to one of the claims 1 to 8, **characterised in that** at least one solar cell (2, 3) is equipped with at least one element which is able to convert low-energy photons into higher-energy photons, in particular a high-converter.

10. Photovoltaic device (10) according to one of the claims 1 to 9, **characterised in that** the respective band gaps of the solar cells (2, 3) with different band gaps are adjusted such that all the solar cells (2, 3) supply the same current and/or the geometric dimension of the respective solar cells (2, 3) with different band gaps is adjusted such that all the solar cells (2, 3) supply the same current.

11. Photovoltaic device (10) according to one of the claims 1 to 10, **characterised in that** wiring together a plurality of solar cells (2, 3) along one prism axis supplies the same voltage as at least one further wiring together.

12. Photovoltaic device (10) according to one of the claims 1 to 11, **characterised in that** the incident radiation can be concentrated on the photovoltaic device, in particular by lenses, mirrors and/or fluorescence collectors.

13. Photovoltaic device (10) according to one of the claims 1 to 12, **characterised in that** the reflection properties of the light incidence surface in a spectral range which is useable by the at least one solar cell (2, 3) is reduced, in particular by a coating (6) or by nanostructuring (6).

14. Photovoltaic device (10) according to one of the claims 1 to 13, **characterised in that** a body with a prism structure (1') is disposed below the light trap (1).

15. Use of the photovoltaic device (10) according to one of the claims 1 to 14 for conversion of solar energy into electrical energy or for detecting electromagnetic radiation.

**Revendications**

1. Dispositif photovoltaïque (10) destiné à la conversion directe d'un rayonnement électromagnétique en énergie électrique, contenant

   a) au moins un piège à lumière (1) qui se compose d'un matériau transparent avec un indice de réfraction plus élevé que l'air, le piège à lumière (1) comportant une surface plane tournée vers le rayonnement incident et une surface éloignée du rayonnement incident et munie d'une structure prismatique, et les prismes de la structure prismatique comportant respectivement une première (8) et une deuxième (9) surface prismatique,
   b) au moins deux cellules solaires (2, 3) qui sont disposées directement sur au moins deux surfaces prismatiques (8, 9) ou couplées optiquement à celles-ci

   **caractérisé en ce que** des cellules solaires (2, 3) dotées d'une sensibilité spectrale différente sont disposées sur des surfaces prismatiques (8, 9) voisines et, pour les angles $\alpha_1$ et $\alpha_2$ que les surfaces prismatiques (8, 9) forment respectivement avec la perpendiculaire à la surface d'entrée de lumière, on a :

   $$\alpha_1, \alpha_2 \leq \arccos(1/n)$$

   où n = indice de réfraction du matériau,
   de telle sorte que le rayonnement arrivant dans le piège à lumière (1) est, après réflexion sur les surfaces prismatiques (8, 9) par réflexion totale, maintenu dans le piège à lumière (1) sur la surface plane,
   au moins une structure (5) spectralement sélective étant disposée entre au moins une surface prismatique (8, 9) et au moins une cellule solaire (2, 3), et transmettant au moins partiellement le rayonnement du domaine spectral exploitable par la cellule solaire (2, 3), et réfléchissant au moins partiellement le rayonnement du domaine spectral non exploitable par la cellule solaire (2, 3), et/ou
   au moins un réflecteur (4, 7) étant disposé au moins par tronçons directement sur le côté de la cellule solaire (2, 3) au moins au nombre de un qui est éloigné de la surface prismatique (8, 9), et/ou sur au moins une surface prismatique (8, 9).

2. Dispositif photovoltaïque (10) selon la revendication 1, **caractérisé en ce que** le réflecteur se présente sous la forme d'un revêtement de la cellule solaire (2, 3) et/ou de la surface prismatique (8, 9).

3. Dispositif photovoltaïque (10) selon l'une des revendications 1 à 2, **caractérisé en ce qu'**au moins un réflecteur (4, 7) est disposé sur au moins une surface latérale du piège à lumière (1) au moins par tronçons, en particulier sous forme d'un revêtement de la surface latérale du piège à lumière (1).

4. Dispositif photovoltaïque (10) selon l'une des revendications 2 ou 3, **caractérisé en ce que** la structure (5) spectralement sélective est disposée sous la forme d'un revêtement de la cellule solaire (2, 3) et/ou de la surface prismatique (8, 9).

5. Dispositif photovoltaïque (10) selon l'une des revendications 2 à 4, **caractérisé en ce que** la structure (5) spectralement sélective au moins au nombre de un se compose de SiN, SiC, TiO, PMMA, TaO, polystyrène, cristaux liquides cholestériques et/ou MgF ou contient ceux-ci de façon notable.

**6.** Dispositif photovoltaïque (10) selon l'une des revendications 1 à 5, **caractérisé en ce que** le piège à lumière (1) se compose de verre, de matière plastique transparente et/ou de vitrocéramique.

**7.** Dispositif photovoltaïque (10) selon l'une des revendications 1 à 6, **caractérisé en ce que** le matériau transparent

a) présente un indice de réfraction d'au moins 1,4, en particulier d'au moins 1,5, et/ou
b) focalise la totalité de la lumière pénétrant dans le piège à lumière (1) en un cône de lumière correspondant à l'angle limite de la réflexion totale.

**8.** Dispositif photovoltaïque (10) selon l'une des revendications 1 à 7, **caractérisé en ce que** le dispositif comporte au moins deux cellules solaires (2, 3) en matériaux semiconducteurs ayant différents intervalles de bande, et/ou au moins une cellule solaire (2, 3) est une cellule solaire tandem ou une cellule solaire multiple.

**9.** Dispositif photovoltaïque (10) selon l'une des revendications 1 à 8, **caractérisé en ce qu'**au moins une cellule solaire (2, 3) est équipée d'au moins un élément qui est en mesure de convertir des photons à basse énergie en photons à haute énergie, en particulier un convertisseur rehausseur.

**10.** Dispositif photovoltaïque (10) selon l'une des revendications 1 à 9, **caractérisé en ce que** les bandes interdites respectives des cellules solaires (2, 3) sont réglées avec des bandes interdites différentes de telle sorte que toutes les cellules solaires (2, 3) fournissent le même courant, et/ou la dimension géométrique des cellules solaires (2, 3) respectives est réglée avec des bandes interdites différentes de telle sorte que toutes les cellules solaires (2, 3) fournissent le même courant.

**11.** Dispositif photovoltaïque (10) selon l'une des revendications 1 à 10, **caractérisé en ce qu'**une interconnexion de plusieurs cellules solaires (2, 3) le long d'un axe prismatique fournit la même tension qu'au moins une autre interconnexion.

**12.** Dispositif photovoltaïque (10) selon l'une des revendications 1 à 11, **caractérisé en ce qu'**un rayonnement incident peut être concentré sur le dispositif photovoltaïque, en particulier par des lentilles, des miroirs et/ou des collecteurs fluorescents.

**13.** Dispositif photovoltaïque (10) selon l'une des revendications 1 à 12, **caractérisé en ce que** les caractéristiques de réflexion de la surface d'entrée de lumière sont réduites dans un domaine spectral utilisable par la cellule solaire (2, 3) au moins au nombre de un, en particulier réduites par un revêtement (6) ou par une nanostructuration (6).

**14.** Dispositif photovoltaïque (10) selon l'une des revendications 1 à 13, **caractérisé en ce qu'**un corps avec une structure prismatique (1') est disposé au-dessous du piège à lumière (1).

**15.** Utilisation du dispositif photovoltaïque (10) selon l'une des revendications 1 à 14 pour la conversion d'énergie solaire en énergie électrique ou pour la détection d'un rayonnement électromagnétique.

**Figur 1**

EP 2 534 701 B1

**Figur 2**

**Figur 3**

EP 2 534 701 B1

# Figur 4

$\beta_1 = \beta_2$

$\beta_1$

$\beta_2$

10

EP 2 534 701 B1

# Figur 5

$\alpha_1$  $\alpha_2$

8

10

EP 2 534 701 B1

**Figur 6**

# Figur 7

# Figur 8

**Figur 9**

## EP 2 534 701 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007058971 A1

**In der Beschreibung aufgeführte Nicht-Patentliteratur**

- **A. DE VOS.** On the formula for the upper limit of photovoltaic solar energy conversion efficiency. *J. Phys. D: Appl. Phys.,* 1982, vol. 15, 2003-2015
- **A. G. IMENES ; D. BUIE ; D. R. MILLS ; P. SCHRAMEK ; S. G. BOSI.** A new strategy for improved spectral performance in solar power plants. *Sol. Energy,* 2006, vol. 80, 1263-1269
- **A. BARNETT.** Milestones toward 50 % efficient solar cell modules. *Proceedings of the 22nd European Photovoltaic Solar Energy Conference,* 2007
- **A. GOETZBERGER ; J.C. GOLDSCHMIDT ; M. PETERS ; P. LÖPER.** Light trapping, a new approach to spectrum splitting. *Solar Energy Materials & Solar Cells,* 2008, vol. 92, 1570-1578